Europäisches Patentamt

European Patent Office

Office européen des brevets

(11) Veröffentlichungsnummer: **0 196 414**
**A2**

(12) ## EUROPÄISCHE PATENTANMELDUNG

(21) Anmeldenummer: 86100967.8

(22) Anmeldetag: 24.01.86

(51) Int. Cl.⁴: **H 01 C 10/14**
**F 16 H 19/00**

(30) Priorität: 29.03.85 DE 3511466

(43) Veröffentlichungstag der Anmeldung:
08.10.86 Patentblatt 86/41

(84) Benannte Vertragsstaaten:
AT DE GB

(71) Anmelder: ANT Nachrichtentechnik GmbH
Gerberstrasse 33
D-7150 Backnang(DE)

(72) Erfinder: Schütte, Holger, Dipl.-Ing.
Tannenweg 16
D-3340 Wolfenbüttel(DE)

(74) Vertreter: Wiechmann, Manfred, Dipl.-Ing.
ANT Nachrichtentechnik GmbH Gerberstrasse 33
D-7150 Backnang(DE)

(54) Durch einen Motor stellbarer Pegelsteller.

(57) Ein Pegelsteller, der von Hand wie ein Flachbahnpegelsteller bedienbar und durch einen Motor (9) stellbar ist, weist in einem Gehäuse (1) einen Stellungsgeber (5) auf, der mit einer translatorisch bewegbaren Handhabe (4) des Pegelstellers gekoppelt ist. Ein Motor (9) mit einem Antriebsrad (10) kann den Stellungsgeber (5), einen damit gekuppelten Pegelsteller (7) und die Handhabe (4) so bewegen, daß eine früher eingespeicherte Stellung reproduzierbar ist. Zur Vermeidung von Regelschwingungen ist der Motor (9) mit dem Stellungsgeber (5) über eine Welle (8) starr gekuppelt. Anwendung für die Einstellung des Pegels elektrischer Signale, beispielsweise in Tonstudios.

EP 0 196 414 A2

BR 89/28 0196414

## Durch einen Motor stellbarer Pegelsteller

Die Erfindung betrifft einen durch einen Motor stellbaren Pegelsteller nach dem Oberbegriff des Patentanspruches 1. Er kann zur Einstellung des Pegels elektrischer Schwingungsgemische beispielsweise in Tonstudios dienen.

Ein solcher Pegelsteller befindet sich im Handel. Bei ihm ist auf zwei Führungsstangen gleitend eine Handhabe (Stellknopf) vorgesehen, durch welche zwei Stellglieder betätigt werden können, indem nämlich zwei Schleifer je eines Flachbahnpotentiometers bewegt werden. Eines dieser Potentiometer bildet den eigentlichen Pegelsteller, während das andere als Stellungsgeber dient. Die vom Stellungsgeber abgreifbare Spannung ist ein Maß für die jeweilige Stellung des Stellknopfes. Diese Spannung kann (bevorzugt digital) gespeichert werden. Sie dient nach Abspeicherung und Wiederauslesung zur Steuerung eines Motors, der ebenfalls in dem im Handel erhältlichen Pegelsteller vorgesehen ist und über einen Zahnriemen die Handhabe (Stellknopf) jeweils so lange antreibt, bis die Spannung an dem ebenfalls mit der Handhabe verbundenen Schleifer des Stellungsgebers mit der aus dem Speicher ausgelesenen Spannung übereinstimmt. Auf diese Weise ist die bei der Einspeicherung vorhanden gewesene Stellung der Handhabe wieder erreicht.

Abgesehen davon, daß bei diesem bekannten Pegelsteller die Flachbahnpotentiometer nicht staubgeschützt sind, kann es bei dem bekannten Pegelsteller dann zu Regelschwingungen kommen, wenn eine abgespeichert gewesene Stellung der Handhabe durch den Motor reproduziert wird. Diese Regelschwingungen lassen sich zwar durch einen erhöhten Aufwand für

BZ 189 6414

die Regelschaltung vermeiden, die zur Steuerung des Motors dient, dabei muß aber in Kauf genommen werden, daß bei der Reproduzierung der eingespeichert gewesenen Stellung der Handhabe eine relativ große Ungenauigkeit auftritt.

Die Aufgabe der Erfindung besteht darin, Regelschwingungen auf andere Weise weitgehend zu vermeiden.

Diese Aufgabe wird gelöst durch den Pegelsteller mit den Merkmalen des Patentanspruches 1. Vorteilhafte Weiterbildungen sind in den Unteransprüchen angegeben.

Die Erfindung geht dabei von folgenden Überlegungen aus: Bei dem bekannten Pegelsteller ist für die Kopplung des Motors mit den Stellgliedern ein relativ elastisches System (Zahnriemen, Zahnräder, etc.) vorgesehen; die dadurch entstehenden Probleme (Spiel, Toleranzen, Dehnung, etc.), können dazu führen, daß dann, wenn bei der Reproduzierung einer gespeichert gewesenen Stellung der Handhabe der Stellungsgeber seine Soll-Lage erreicht hat, der Motor zwar stillgesetzt wird, die Handhabe mit dem Stellungsgeber aber dennoch ein kleines Stück weiterfährt. Dadurch wird die Soll-Lage überschritten, und die Regelschaltung setzt den Motor wieder in umgekehrter Richtung in Bewegung. Es entsteht eine Regelschwingung.

Durch die erfindungsgemäße Ausgestaltung des Pegelstellers wird das mit Spiel, Tolerenzen und Dehnung behaftete elastische System zwischen dem Stellungsgeber und dem Motor beseitigt und durch eine in Drehrichtung spielfreie, insbesondere starre Kupplung ersetzt. Dies ist durch die Verwendung eines Drehgebers (auch Drehwinkelgeber genannt) anstelle eines Flachbahnpotentiometers möglich. Die Verwendung eines Drehgebers bringt weiterhin den Vorteil mit sich, daß er sich auf einfache Weise staubschützend gekapselt ausbilden läßt. Entsprechendes gilt für einen für die Pegelstellung verantwortlichen Steller, der als Drehsteller ausgebildet sein kann und auch durch die Welle des Motors unmittelbar oder über eine in Drehrichtung spielfreie Kupplung antreibbar ist.

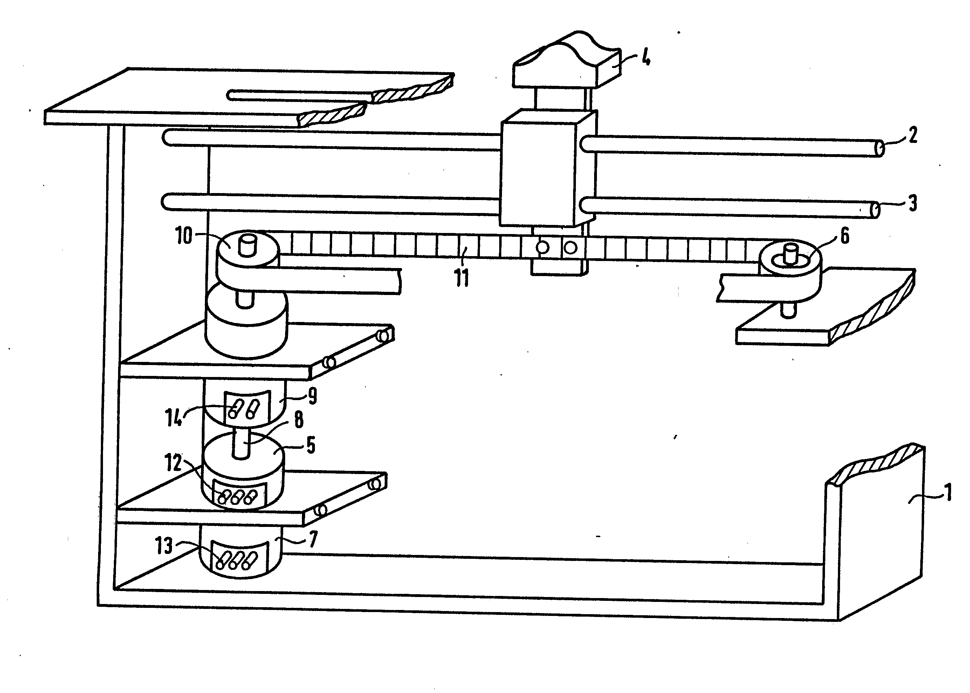

Anhand der Zeichnung wird ein bevorzugtes Ausführungsbeispiel des erfindungsgemäßen Pegelstellers beschrieben. In einem Gehäuse 1 sind zwei Führungsstangen 2 und 3 für eine Handhabe 4 vorgesehen, die dazu dient, letztlich die gemeinsame Welle 8 zweier Stellglieder zu drehen, nämlich eines Stellungsgebers 5 und eines Stellers 7, deren Funktion weiter unten noch beschrieben wird. Zur Bewegungskopplung zwischen der Handhabe 4 und der Welle 8 sind ein Zahnriemen 11 mit Umlenkrolle 6 und ein fest auf der Welle 8 sitzendes Antriebsrad 10 vorgesehen.

Wird die Handhabe 4 bewegt, so wird die Stellung des als Drehgeber 5 ausgebildeten Stellungsgebers verändert, so daß an dessen Klemmen 12 veränderte Signale abgegriffen werden können, welche für die Stellung der Handhabe 4 representativ sind. Diese Signale können gespeichert und später zur Reproduktion der Stellung der Handhabe 4 wieder abgerufen werden. Dazu ist eine hier nicht dargestellte Speicher- und Schaltungsanordnung vorzusehen.

Mit der Welle 8 wird auch der als Drehsteller 7 ausgebildete Steller betätigt. Die an dessen Klemmen 13 auftretenden Signale sind für die Pegelstellung elektrischer, beispielsweise tonfrequenter Signale verantwortlich. Diese Pegelstellung ist der Hauptzweck des dargestellten Pegelstellers mit seiner Handhabe 4.

Dagegen sind der Drehgeber 5 und ein mit ihm über die Welle 8 starr gekuppelter Motor 9 lediglich Hilfsmittel, um den Drehsteller 7 und die Handhabe 4 motorisch in bestimmte Stellungen zu bewegen, aufgrund von Signalen, welche den Motorklemmen 14 zugeführt werden.

Abgesehen davon, daß sich der Drehsteller 7 und/oder der Drehgeber 5 auf einfache Weise staubdicht kapseln lassen, ist durch die Dauerkupplung in Gestalt der gemeinsamen Welle 8 zwischen dem Drehgeber 5 und dem Motor 9 dafür gesorgt, daß der Drehgeber 5 unter Vermeidung von Regelschwingungen genauer als bisher durch den Motor 9 in die jeweilige Soll-Stellung gebracht werden kann. Durch die starre Kupplung zwischen dem Drehgeber 5 und dem Drehsteller 7 ist weiterhin dafür gesorgt, daß auch der Drehsteller 7 seine jeweilige Soll-Stellung genau erreicht, wenn der Drehgeber 5 die seinige erreicht hat. Lediglich zwischen dem Antriebsrad 10 und der Handhabe 4 befinden sich noch Teile mit Spiel, Toleranzen und Dehnung, so daß bei der Bewegung der Handhabe 4 durch den Motor 9 Ungenauigkeiten auftreten können. Diese sind aber unwesentlich, da sie bei der Reproduzierung von Drehgeber- oder Drehsteller-Stellungen durch den Motor 9 ohne Einfluß auf die Signale an den Klemmen 12 und 13 sind.

Bei dem dargestellten Ausführungsbeispiel sind der Motor 9, der Drehgeber 5 und der Drehsteller 7 mit dem Gehäuse 1 und das Gegenstück (Zahnriemen) 11 mit der Handhabe 4 jeweils fest verbunden. Eine mögliche Abwandlung besteht darin, daß der Zahnriemen 11 durch eine nicht mit der Handhabe 4 son-dern mit dem Gehäuse 1 fest verbundene Zahnstange (Gegenstück) ersetzt wird und dann der Motor 9 und der Drehgeber 5 mitsamt dem Drehsteller 7 fest mit der Handhabe 4 verbunden sind. Die Teile 5 und 7 bis 10 werden dann mitsamt der Handhabe 4 bewegt, wobei das Antriebsrad 10 auf dem ortsfesten Gegenstück (z.B. Zahnstange) abrollt.

0196414

_5_
- X -

ANT Nachrichtentechnik GmbH                    E7/Wn/fa
Gerberstraße 33                                BK 85/28
7150 Backnang


Patentansprüche


1. Durch einen Motor (9) stellbarer und von Hand wie ein
   Flachbahnpegelsteller bedienbarer Pegelsteller mit Gehäuse (1), mit einem Stellungsgeber der mit einer translatorisch bewegbaren Handhabe (4) des Pegelstellers gekoppelt ist, und bei dem ein Antriebsrad (10) des Motors
   (9) vorgesehen ist, um schlupfarm Antriebskräfte gegenüber einem gestreckten Gegenstück (11) auszuüben,
   dadurch gekennzeichnet, daß als Stellungsgeber ein Drehgeber (5) vorgesehen ist, der durch die Welle (8) des
   Motors (9) unmittelbar oder über eine in Drehrichtung
   spielfreie Kupplung antreibbar ist.

2. Pegelsteller nach Anspruch 1, dadurch gekennzeichent,
   daß außer dem Drehgeber (5) auch ein für die Pegelstellung verantwortlicher Steller als Drehsteller (7) ausgebildet und durch die Welle (8) des Motors (9) unmittelbar oder über eine in Drehrichtung spielfreie Kupplung
   antreibbar ist.

3. Pegelsteller nach Anspruch 1, dadurch gekennzeichnet, daß der Drehgeber (5) staubschützend gekapselt ist.

4. Pegelsteller nach Anspruch 2, dadurch gekennzeichnet, daß der Drehsteller (7) staubschützend gekapselt ist.

5. Pegelsteller nach einem der vorangehenden Ansprüche, dadurch gekennzeichnet, daß Motor (9) und Drehgeber (5) bzw. Drehsteller (7) mit dem Gehäuse (1) und das Gegenstück (11) mit der Handhabe (4) jeweils unmittelbar oder mittelbar fest verbunden sind.

6. Pegelsteller nach einem der Ansprüche 1 bis 4, dadurch gekennzeichnet, daß das Gegenstück (11) mit dem Gehäuse (1) und der Motor (9) und der Drehgeber (5) bzw. Drehsteller (7) mit der Handhabe (4) jeweils unmittelbar oder mittelbar verbunden sind.

1/1

0196414